# EUROPÄISCHE PATENTSCHRIFT

(11) **EP 1 230 442 B1**
(45) Veröffentlichungstag und Bekanntmachung des Hinweises auf die Patenterteilung: **16.07.2003**
(21) Anmeldenummer: 00981161.3
(22) Anmeldetag: 06.11.2000
(51) Int. Cl.: C25D 5/00

(54) **VORRICHTUNG ZUR ELEKTROLYTISCHEN BEHANDLUNG VON PLATTENFÖRMIGEN WERKSTÜCKEN, INSBESONDERE VON LEITERPLATTEN**
DEVICE FOR ELECTROLYTICALLY TREATING BOARD-SHAPED WORKPIECES, ESPECIALLY PRINTED CIRCUITS
DISPOSITIF DE TRAITEMENT ELECTROLYTIQUE DE PIECES SOUS FORME DE PLAQUES, NOTAMMENT DES CARTES DE CIRCUITS

(30) Priorität: 09.11.1999 DE 19953878
(43) Veröffentlichungstag der Anmeldung: 14.08.2002
(73) Patentinhaber: SIEMENS AKTIENGESELLSCHAFT, 80333 München (DE)
(72) Erfinder: DENYS, Wilfried, B-8020 Oostkamp (BE)
(86) Internationale Anmeldenummer: DE0003884
(87) Internationale Veröffentlichungsnummer: WO01034881

(56) Entgegenhaltungen:
- DE-A- 3 419 819
- US-A- 4 401 522
- US-A- 4 459 183
- US-A- 5 827 410
- US-A- 5 897 756
- PATENT ABSTRACTS OF JAPAN vol. 2000, no. 09, 13. Oktober 2000 (2000-10-13) & JP 2000 178784 A (KEMITORON:KK), 27. Juni 2000 (2000-06-27) -& DATABASE WPI Derwent Publications Ltd., London, GB; AN 2000-479027 XP002168681
- PATENT ABSTRACTS OF JAPAN vol. 011, no. 024 (C-399), 23. Januar 1987 (1987-01-23) & JP 61 195996 A (HITACHI CABLE LTD), 30. August 1986 (1986-08-30)
- PATENT ABSTRACTS OF JAPAN vol. 009, no. 125 (C-283), 30. Mai 1985 (1985-05-30) & JP 60 013096 A (SAWA HIYOUMEN GIKEN KK), 23. Januar 1985 (1985-01-23)
- PATENT ABSTRACTS OF JAPAN vol. 2000, no. 05, 14. September 2000 (2000-09-14) & JP 2000 064088 A (EBARA YUUJIRAITO KK), 29. Februar 2000 (2000-02-29)

## Beschreibung

Aus der EP-A-0 421 127 ist eine Vorrichtung zur Behandlung von Leiterplatten bekannt, bei welcher die einzelnen Leiterplatten in senkrecht hängender Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über an endlos umlaufenden Trieben angeordnete Klammern, die im Falle einer galvanischen Metallabscheidung gleichzeitig auch die kathodische Kontaktierung der Leiterplatten übernehmen. In den Stirnwänden der Behandlungszellen befinden sich vertikale Schlitze für den Durchtritt der Leiterplatten, wobei im Durchtrittsbereich als Bürstendichtungen oder Streifenbürstendichtungen ausgebildete Dichtungen vorgesehen sind. Die einzelnen Behandlungszellen sind in Auffangwannen angeordnet, aus welchen die aufgefangene Badflüssigkeit mit Hilfe entsprechender Pumpen kontinuierlich in die zugeordneten Behandlungszellen zurückgeführt wird. Die Rückführung von Badflüssigkeit in eine Behandlungszelle erfolgt dabei über eine druckseitig an die zugehörige Pumpe angeschlossene Zuleitung, deren Mündung in einer Stirnwand unter dem vertikalen Schlitz für den Durchtritt der Leiterplatten liegt und horizontal in die Behandlungszelle gerichtet ist. Die einströmende Badflüssigkeit soll sich dadurch gleichmäßig auf die beiden Seiten der Leiterplatten verteilen.

Aus der US-A-4 401 522 ist eine ähnlich aufgebaute Vorrichtung zur elektrolytischen Behandlung von Werkstücken, wie z.B. Leiterplatten, bekannt, bei welcher den vertikalen Schlitzen in den Stirnwänden der Behandlungszellen als Dichtungen vertikal angeordnete Walzenpaare zugeordnet sind. Die Rückführung von Badflüssigkeit in eine Behandlungszelle erfolgt hier über zwei zu beiden Seiten des Transportweges angeordnete Reihen von vertikal ausgerichteten Sprührohren, die jeweils in Längsrichtung mit einer Reihe von auf die Werkstücke gerichteten Sprühöffnungen versehen sind. Die Versorgung der Sprührohre erfolgt über eine im Bodenbereich der Behandlungszelle gebildete Verteilkammer, die ihrerseits über die Pumpe mit Badlösung aus der Auffangwanne versorgt wird.

Aus der US-A-5 827 410 ist eine weitere Vorrichtung zur elektrolytischen Behandlung von plattenförmigen Werkstücken, insbesondere von Leiterplatten, bekannt, bei welcher die plattenförmigen Werkstücke mit Hilfe von Kontaktier- und Transportmitteln in vertikaler Lage auf einem horizontalen Transportweg durch eine ein Behandlungsbad enthaltende Behandlungszelle geführt werden, deren Stirnwände vertikale Schlitze für den Durchtritt der Werkstücke besitzen. Die aus der Behandlungszelle austretende Badflüssigkeit wird in einer Auffangwanne aufgefangen und mit Hilfe einer Pumpe derart in die Behandlungszelle zurückgeführt, daß sich zu beiden Seiten des Transportweges eine zumindest weitgehend vertikale Strömungsrichtung ergibt. Durch zu beiden Seiten des Transportweges in der Behandlungszelle angeordnete Leitvorrichtungen wird die Badflüssigkeit zur Oberfläche der Werkstücke hin umgeleitet. Durch die Leitvorrichtungen wird im Bereich der Werkstücke ein verbesserter Ionenaustausch bewirkt. Somit kann beispielsweise bei der galvanischen Behandlung von Leiterplatten die Metallabscheidung mit relativ hohen Stromdichten vorgenommen werden. Die Leitvorrichtungen sind dabei derart angeordnet, daß sie eine Führung für die Werkstücke bilden.

Bei der aus der US-A-5 827 410 bekannten Vorrichtung kann die zu beiden Seiten der Werkstücke aufsteigende Badflüssigkeit teilweise seitlich wegströmen. Je nach Höhe der plattenförmigen Werkstücke kann es hierdurch im oberen Bereich der Werkstücke zu einer unzureichenden seitlichen Anströmung und damit zu einem unzureichenden Ionenaustausch kommen. Wird dann die Stromdichte nicht reduziert, so führt der unzureichende Ionenaustausch zu Verbrennungen im oberen Bereich der Werkstücke. Demzufolge kann beispielsweise beim Galvanisieren ohne starke Luft- oder Gaseinblasung nicht mit hohen Stromdichten gefahren werden. Durch die starke Turbulenz, zu der die Plattenanströmung mit zusätzlicher starker Luft- oder Gaseinblasung führt, können dünne Werkstücke sich verbiegen und ggf. in den Leitvorrichtungen hängenbleiben. Eine andere negative Folge von starker Luft- oder Gaseinblasung ist ein stark erhöhter Verbrauch an Additiven.

Der im Anspruch 1 angegebenen Erfindung liegt das Problem zugrunde, eine Vorrichtung zur elektrolytischen Behandlung von vertikal ausgerichteten plattenförmigen Werkstücken zu schaffen, bei welcher mit einfachen Mitteln beide Seiten der durchlaufenden Werkstücke ganzflächig und uniform angeströmt werden.

Die mit der Erfindung erzielten Vorteile bestehen insbesondere darin, daß im Bereich der Sprührohre eine von anderen Einflüssen völlig unabhängige seitliche Anströmung der durchlaufenden Werkstücke gewährleistet ist. Durch die Neigung der Sprührohre zur Horizontalen wird einerseits eine streifenförmige Abdeckung der Feldlinien zwischen Elektroden und Werkstücken vermieden und andererseits eine besonders gleichmäßige Anströmung der Werkstücke gewährleistet. Durch den mit dieser gleichmäßigen Anströmung verbesserten Ionenaustausch können dann die Stromdichten der elektrolytischen Behandlung auch bei höheren Werkstücken erheblich gesteigert werden. Außerdem kann auf eine zusätzliche Luft- oder Gaseinblasung in den meisten Fällen vollständig verzichtet werden.

Vorteilhafte Ausgestaltungen der Erfindung sind in den Unteransprüchen angegeben.

Die Ausgestaltung nach Anspruch 2 ermöglicht die gleichzeitige Verwendung der Sprührohre als Führung für die plattenförmigen Werkstücke.

Gemäß Anspruch 3 kann die Rückführung von Badflüssigkeit in die Behandlungszelle teilweise über die Sprührohre und teilweise über eine im Bodenbereich der Behandlungszelle gebildete Verteilkammer vorgenommen werden. In diesem Fall können dann auch gemäß Anspruch 4 im unteren Bereich der Werkstücke zu beiden Seiten des Transportweges Leitvorrichtungen in der Behandlungszelle angeordnet werden, welche die aus der Verteilkammer nach oben strömende Badflüssigkeit zur Oberfläche der Werkstücke hin umleiten. Auf die Anordnung von Sprührohren im unteren Bereich der Werkstücke kann in diesem Fall dann verzichtet werden.

Die Weiterbildung nach Anspruch 5 ermöglicht eine flexible Einstellung der Anströmwinkel der aus den Sprührohren auf die Werkstücke gerichteten Flüssigkeitsströmung. Hierdurch kann für jedes Werkstück eine optimale Einstellung der Anströmwinkel erzielt werden.

Für die Neigung der Sprührohre zur Horizontalen haben sich gemäß Anspruch 6 Neigungswinkel zwischen 5° und 30° als besonders geeignet erwiesen. Bei Neigungswinkeln zwischen 5° und 15° gemäß Anspruch 7 werden optimale Ergebnisse und eine besonders gleichmäßige Anströmung der Werkstücke erzielt.

Die Weiterbildung nach Anspruch 8 ermöglicht eine besonders einfache Befestigung der Sprührohre innerhalb des Behandlungsbades. Die für die Befestigung der Sprührohre verwendeten Träger können dann gemäß Anspruch 9 mit einem für die Badflüssigkeit durchlässigen Tuch oder Vlies bespannt werden. Hierdurch kann im Bereich zwischen Trägern und Werkstücken eine besonders effiziente Elektrolytbewegung realisiert werden.

Ausführungsbeispiele der Erfindung sind in der Zeichnung dargestellt und werden im folgenden näher beschrieben.
Es zeigen
- Figur 1 und Figur 2: in stark vereinfachter schematischer Darstellung eine Vorrichtung zur elektrolytischen Behandlung von plattenförmigen Werkstücken in der Draufsicht bzw. im Querschnitt,
- Figur 3: einen Querschnitt durch eine erste Ausführungsform der Behandlungszelle einer Vorrichtung gemäß den Figuren 1 und 2,
- Figur 4: einen Querschnitt durch eine zweite Ausführungsform der Behandlungszelle einer Vorrichtung gemäß den Figuren 1 und 2 und
- Figur 5: eine Draufsicht auf die schräg angeordneten Sprührohre der in Figur 4 dargestellten Behandlungszeile.

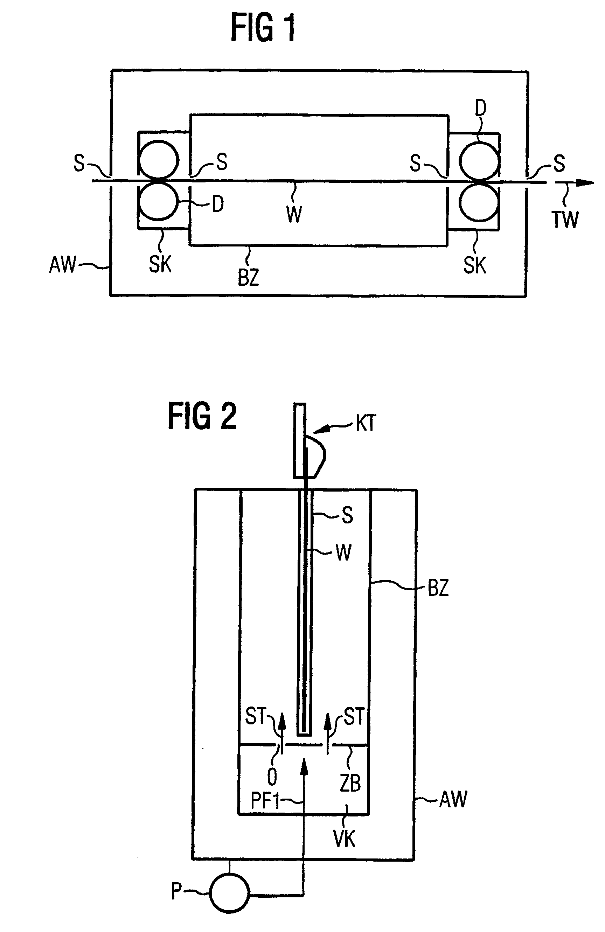

Die Figuren 1 und 2 zeigen in der Draufsicht bzw. im Querschnitt eine in einer Auffangwanne AW angeordnete, ein elektrolytisches Behandlungsbad enthaltende Behandlungszelle BZ, durch welche an Kontaktier- und Transportmitteln KT senkrecht hängende plattenförmige Werkstücke W auf einem horizontalen Transportweg TW hindurchgeführt werden. An den beiden Stirnwänden der Behandlungszelle BZ befinden sich Schleusenkammern SK, in welchen durch kreiszylindrische Kunststoffrohre gebildete Dichtungen D paarweise und in vertikaler Ausrichtung lose angeordnet sind. Diese Dichtungen D werden dabei durch den Druck der Badflüssigkeit gegeneinander oder gegen das jeweils durchlaufende Werkstück W gedrückt. Die Stirnwände der Behandlungszellen BZ, der Schleusenkammern SK und der Auffangwanne AW, sind mit vertikalen Schlitzen S versehen, durch welche die plattenförmigen Werkstücke W unbehindert hindurchgeführt werden können. Die aus der Behandlungszelle BZ im Bereich der Schleusenkammern SK austretende und ggf. auch über die Wände der Behandlungszelle BZ überlaufende Badflüssigkeit wird in der Auffangwanne AW aufgefangen und über eine Pumpe P kontinuierlich in die Behandlungszelle BZ zurückgeführt, so wie es in Figur 2 durch einen Pfeil PF1 angedeutet ist.

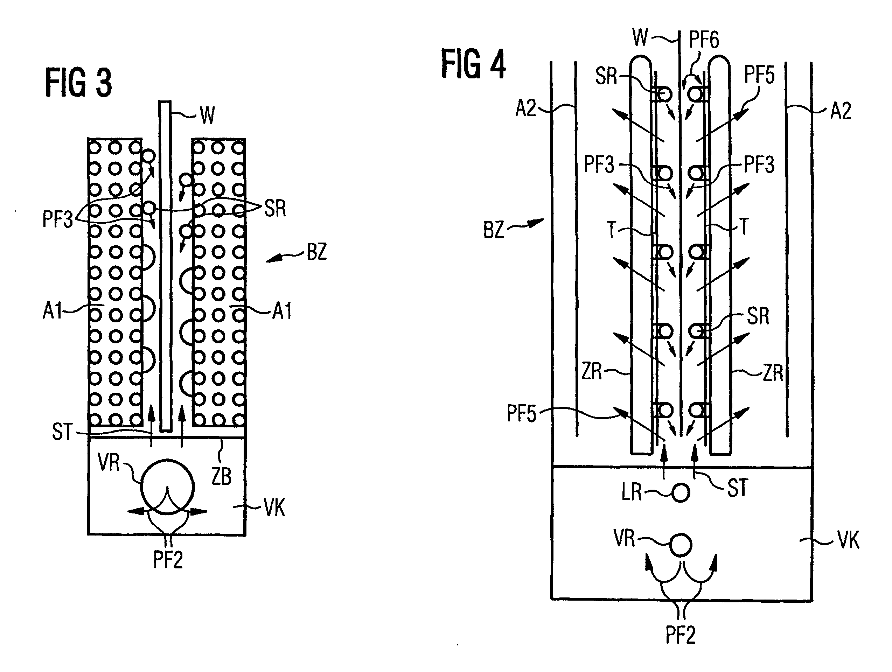

Zu beiden Seiten des Transportweges TW sind in der Behandlungszelle BZ in den Figuren 1 und 2 nicht dargestellte Elektroden angeordnet, welche die entgegengesetzte Polarität der Kontaktier- und Transportmittel KT aufweisen. Im Falle einer galvanischen Metallabscheidung auf die Werkstücke W werden diese über die Kontaktier- und Transportmittel KT kathodisch kontaktiert, während es sich bei den anhand der Figuren 3 und 4 noch näher zu erläuternden Elektroden um Anoden handelt. Im Falle eines gepulsten Galvanisierbetriebes werden die Elekroden abwechselnd als Anoden oder Kathoden geschaltet.

Die bereits erwähnte Rückführung von Badflüssigkeit in die Behandlungszelle BZ erfolgt teilweise über eine Verteilkammer VK, so wie es in Figur 2 durch den Pfeil PF1 angedeutet ist. Diese im Bodenbereich der Behandlungszelle BZ durch einen Zwischenboden ZB gebildete Verteilkammer VK ist mit zwei Reihen von Öffnungen O versehen, die zu beiden Seiten des Transportweges TW in den Zwischenboden ZB eingebracht sind. Durch diese Öffnungen O strömt dann die von der Pumpe P zum Teil in die Verteilkammer geförderte Badflüssigkeit mit einer vertikalen Strömungsrichtung zu beiden Seiten der Werkstücke W nach oben, so wie es in Figur 2 durch die Pfeile ST angedeutet ist. Die nach oben strömende Badflüssigkeit wird dann durch in den Figuren 1 und 2 nicht dargestellte Leitvorrichtungen oder auch durch Sprührohre zur Oberfläche der Werkstücke W hin umgeleitet. Verschiedene Möglichkeiten für die Ausgestaltung der Behandlungszellen BZ und für die Anordnung der Leitvorrichtungen und Sprührohre in den Behandlungszellen BZ werden im folgenden anhand der Figuren 3 und 4 näher beschrieben.

Figur 3 zeigt eine erste Ausführungsform einer Behandlungszelle BZ, mit zu beiden Seiten des Transportweges TW (vgl. Figur 1) der Werkstücke W angeordneten Elekroden, bei welchen es sich um lösliche Anoden A1 handelt. Im Falle einer galvanischen Kupferabscheidung bestehen die löslichen Anoden A1 beispielsweise aus Titankörben und darin untergebrachten Kupferkugeln. Auf den den Werkstücken zugewandten Seiten der löslichen Anoden A1 sind Leitvorrichtungen LV angebracht, die durch im vertikalen Abstand zueinander angeordnete und zur Horizontalen jeweils um einen Winkel von 10° geneigte, halbkreisförmige Profile gebildet sind. Die beispielsweise aus hochmolekularem PE bestehenden Leitvorrichtungen LV sind in vertikaler Richtung gesehen alternierend zu beiden Seiten der Werkstücke W angeordnet, d.h. jede Leitvorrichtung LV einer Seite befindet sich genau auf halber Höhe zwischen zwei Leitvorrichtung LV der gegenüberliegenden Seite. Außerdem ist der Abstand zwischen den Leitvorrichtungen LV beider Seiten derart bemessen, daß eine Führung für die durchlaufenden plattenförmigen Werkstücke W gebildet wird.

Im Bodenbereich der Behandlungszelle BZ befindet sich in der durch den Zwischenboden ZB gebildeten Verteilkammer VK ein horizontal ausgerichtetes Verteilrohr VR, welches druckseitig an die Pumpe P (vgl. Figur 2) angeschlossen ist. Dieses Verteilrohr VR ist auf seiner Unterseite mit im Abstand zueinander angeordneten Löchern versehen, aus welchen die Badflüssigkeit austritt, so wie es in Figur 3 durch die Pfeile PF2 angedeutet ist. Wie bereits in Zusammenhang mit Figur 2 erläutert wurde, strömt die Badflüssigkeit dann mit einer vertikalen Strömungsrichtung ST zu beiden Seiten der durchlaufenden Werkstücke W nach oben in die Behandlungszelle BZ. Die nach oben strömende Badflüssigkeit wird dann durch die Leitvorrichtungen LV wiederholt zur Oberfläche der Werkstücke W hin umgeleitet. Insgesamt entsteht zu beiden Seiten der Werkstücke W jeweils eine mäanderförmige Strömung mit jeweils im Bereich einer Leitvorrichtung LV auf die Oberfläche der Werkstücke W gerichteten horizontalen Strömungskomponenten. Durch die alternierende Anordnung der Leitvorrichtungen LV werden bei der Behandlung gelochter Leiterplatten deren Durchkontaktierungslöcher sehr gut durchströmt.

Um nun auch im oberen Bereich der durchlaufenden Werkstücke W einen effektiven Ionenaustausch zu erzielen, sind dort anstelle der Leitvorrichtungen LV Sprührohre SR zu beiden Seiten des Transportweges TW (vgl. Figur 1) angeordnet. Auch diese Sprührohre SR sind in gleicher Weise wie die Leitvorrichtungen LV jeweils um einen Winkel von 10° geneigt. Die druckseitig ebenfalls an die Pumpe P (vgl. Figur 2) angeschlossenen Sprührohre SR sind mit einer Vielzahl von in Figur 3 nicht erkennbaren Ausströmöffnungen versehen, aus welchen die Badflüssigkeit gegen die Werkstücke W strömt, so wie es in Figur 3 durch Pfeile PF3 angedeutet ist. Aus Figur 3 ist auch ersichtlich, daß die beispielsweise aus PVC bestehenden Sprührohre SR derart angeordnet sind, daß sie in gleicher Weise wie die Leitvorrichtungen LV eine Führung für die durchlaufenden plattenförmigen Werkstücke W bilden.

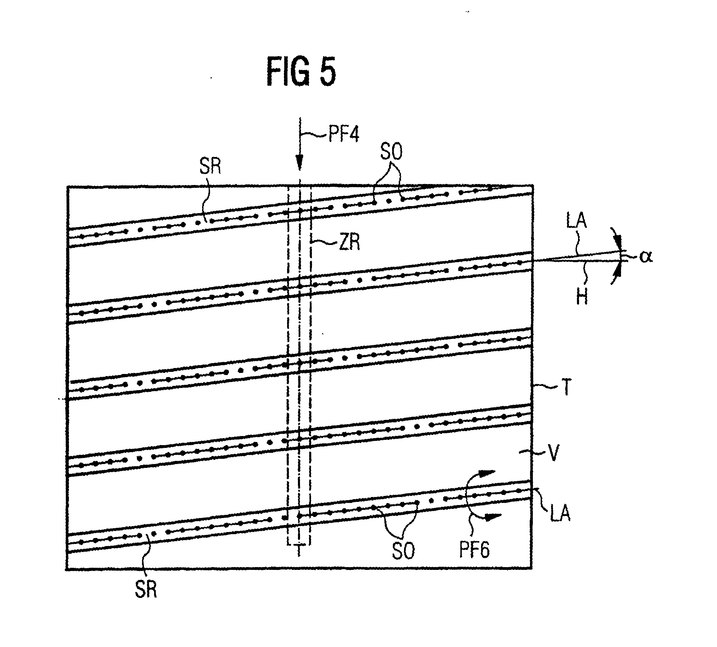

Figur 4 zeigt eine zweite Ausführungsform einer Behandlungszelle BZ mit zu beiden Seiten des Transportweges TW (vgl. Figur 1) der Werkstücke W angeordneten Elekroden. Bei den in Figur 4 lediglich durch Striche A2 angedeuteten Elektroden handelt es sich wieder um lösliche Anoden, die den in Figur 3 dargestellten Anoden A1 entsprechen. Zwischen den löslichen Anoden A2 und den durchlaufenden Werkstücken W befinden sich Träger T, an deren einander zugewandten Innenseiten Sprührohre SR angebracht sind. Hierzu wird ergänzend auf die Figur 5 verwiesen, aus welcher auch die mit gleichmäßigem Teilungsabstand angeordneten Sprühöffnungen SO der Sprührohre SR und die zur Horizontalen geneigte Anordnung der Sprührohre SR hervorgehen. Der mit α bezeichnete Neigungswinkel beträgt beispielsweise 10°. Der Träger T ist mit einem aus Figur 5 ersichtlichen Vlies V bespannt, welches für die Badflüssigkeit durchlässig ist.

Die einzelnen Sprührohre SR sind jeweils paarweise auf gleicher Höhe zu beiden Seiten der durchlaufenden Werkstücke W angeordnet. Dabei sind die einzelnen Sprührohre SR jeder Seite über nicht näher erkennbare T-Stücke an mittig angeordnete und vertikal ausgerichtete Zuführrohre ZR angeschlossen, die ihrerseits druckseitig mit der Pumpe P (vgl. Figur 2) verbunden sind. Diese Zufuhr von Badflüssigkeit von der Pumpe her ist in Figur 5 durch einen Pfeil PF4 angedeutet.

In der Verteilkammer VK der in Figur 4 dargestellten Behandlungszelle BZ ist neben dem Verteilrohr VR ein Luftzufuhrrohr LR angeordnet, durch welches gegebenenfalls Druckluft eingeleitet werden kann und dann zwischen den Sprührohren SR und dem Werkstück W nach oben steigt. Die aus dem Verteilrohr VR geförderte Badflüssigkeit steigt in Richtung der Pfeile ST nach oben und wird dann über die als Leitvorrichtungen dienenden Sprührohre SR zur Oberfläche der Werkstücke W hin umgeleitet. Ein Teil der nach oben strömenden Badflüssigkeit wird durch das Vlies V (vgl. Figur 5) hindurch seitlich abgeleitet, so wie es in Figur 4 durch Pfeile PF5 angedeutet ist. Die aus den Sprührohren SR austretende und auf die Oberfläche der Werkstücke W strömende Badflüssigkeit ist auch in Figur 4 wieder durch Pfeile PF3 angedeutet. Die Sprührohre SR sind auch hier wieder derart angeordnet, daß sie eine Führung für die durchlaufenden Werkstücke W bilden.

Um auch bei der elektrolytischen Behandlung unterschiedlicher Werkstücke W die Anströmung der Werkstückoberflächen über die Sprührohre SR optimieren zu können, sind die einzelnen Sprührohre SR um ihre Längsachsen LA drehbar. Diese Verdrehmöglichkeit der Sprührohre SR ist in den Figuren 4 und 5 durch Doppelpfeile PF6 angedeutet.

## Patentansprüche

1. Vorrichtung zur elektrolytischen Behandlung von plattenförmigen Werkstücken (W), insbesondere von Leiterplatten mit
- Kontaktier- und Transportmitteln (KT), welche die Werkstücke (W) anodisch oder kathodisch kontaktieren und in vertikaler Lage auf einem horizontalen Transportweg (TW) durch mindestens ein Behandlungsbad führen,
- einer Behandlungszelle (BZ) zur Aufnahme des Behandlungsbades,
- zu beiden Seiten des Transportweges (TW) in den Behandlungszellen (BZ) angeordneten Elektroden mit der entgegengesetzten Polarität der Kontaktier- und Transportmittel (KT),
- vertikalen Schlitzen (S) in den Stirnwänden der Behandlungszelle für den Durchtritt der Werkstücke (W),
- einer Auffangwanne (AW) für die aus der Behandlungszelle (BZ) austretende Badflüssigkeit und mit
- mindestens einer Pumpe (P) zur kontinuierlichen Rückführung von Badflüssigkeit aus der Auffangwanne (AW) in die Behandlungszelle (BZ),
**dadurch gekennzeichnet, daß** die Rückführung der Badflüssigkeit zumindest teilweise über Sprührohre (SR) erfolgt, die zumindest im oberen Bereich der Werkstücke (W) zu beiden Seiten des Transportweges (TW) in der Behandlungszelle (BZ) angeordnet sind, wobei die Sprührohre (SR) sich in Richtung des Transportweges (TW) erstrecken und zur Horizontalen (H) geneigt ausgerichtet sind.

2. Vorrichtung nach Anspruch 1,
**dadurch gekennzeichnet, daß** die Sprührohre (SR) derart angeordnet sind, daß sie eine Führung für die Werkstücke (W) bilden.

3. Vorrichtung nach Anspruch 1 oder 2,
**dadurch gekennzeichnet, daß** die Rückführung von Badflüssigkeit in die Behandlungszelle (BZ) teilweise über eine in deren Bodenbereich gebildete Verteilkammer (VK) und über zu beiden Seiten des Transportweges (TW) angeordnete Öffnungen (O) der Verteilkammer (VK) erfolgt.

4. Vorrichtung nach Anspruch 3,
**dadurch gekennzeichnet, daß** im unteren Bereich der Werkstücke (W) zu beiden Seiten des Transportweges (TW) Leitvorrichtungen (LV) in der Behandlungszelle (BZ) angeordnet sind, welche die aus der Verteilkammer (VK) nach oben strömende Badflüssigkeit zur Oberfläche der Werkstücke (W) hin umleiten.

5. Vorrichtung nach einem der vorhergehenden Ansprüche,
**dadurch gekennzeichnet, daß** die Sprührohre (SR) um ihre Längsachse (LA) drehbar angeordnet sind.

6. Vorrichtung nach einem der vorhergehenden Ansprüche,
**dadurch gekennzeichnet, daß** die Sprührohre (SR) zur Horizontalen (H) um einen Winkel (α) zwischen 5° und 30° geneigt sind.

7. Vorrichtung nach einem der Ansprüche 1 bis 5,
**dadurch gekennzeichnet, daß** die Sprührohre (SR) zur Horizontalen (H) um einen Winkel (α) zwischen 5° und 15° geneigt sind.

8. Vorrichtung nach einem der vorhergehenden Ansprüche,
**dadurch gekennzeichnet, daß** die Sprührohre (SR) an zwischen den Werkstücken (W) und löslichen Anoden (A2) angeordneten Trägern (T) angebracht sind.

9. Vorrichtung nach Anspruch 8,
**dadurch gekennzeichnet, daß** die Träger (T) durch mit durchlässigem Tuch oder Vlies (V) bespannte Rahmen gebildet sind.

## Claims

1. Device for electrolytically treating board-shaped workpieces (W), in particular printed-circuit boards, having
- contact-making and conveyor means (KT), which make anodic or cathodic contact with the workpieces (W) and guide them in a vertical position on a horizontal conveyor path (TW) through at least one treatment bath,
- a treatment cell (BZ) for holding the treatment bath,
- electrodes which are arranged on both sides of the conveyor path (TW) in the treatment cells (BZ) and have the opposite polarity to the contact-making and conveyor means (KT),
- vertical slots (S) in the end walls of the treatment cell for the workpieces (W) to pass through,
- a collection trough (AW) for the bath liquid emerging from the treatment cell (BZ), and having
- at least one pump (P) for continuously returning bath liquid from the collection trough (AW) to the treatment cell (BZ),
**characterized in that** the bath liquid is returned at least in part via spray tubes (SR), which at least in the upper region of the workpieces (W) are arranged on both sides of the conveyor path (TW) in the treatment cell (BZ), the spray tubes (SR) extending in the direction of the conveyor path (TW) and being oriented at an angle with respect to the horizontal (H).

2. Device according to Claim 1, **characterized in that** the spray tubes (SR) are arranged in such a manner that they form a guide for the workpieces (W).

3. Device according to Claim 1 or 2, **characterized in that** the returning of bath liquid to the treatment cell (BZ) takes place partially via a distribution chamber (VK) formed in the bottom region of the treatment cell and via openings (O) in the distribution chamber (VK), which are arranged on both sides of the conveyor path (TW).

4. Device according to Claim 3, **characterized in that** diverting devices (LV), which divert the bath liquid which flows upward out of the distribution chamber (VK) toward the surface of the workpieces (W), are arranged on both sides of the conveyor path (TW) in the treatment cell (BZ) in the lower region of the workpieces (W).

5. Device according to one of the preceding claims, **characterized in that** the spray tubes (SR) are arranged in such a manner that they can rotate about their longitudinal axis (LA).

6. Device according to one of the preceding claims, **characterized in that** the spray tubes (SR) are inclined at an angle (α) of between 5° and 30° with respect to the horizontal (H).

7. Device according to one of Claims 1 to 5, **characterized in that** the spray tubes (SR) are inclined at an angle (α) of between 5° and 15° with respect to the horizontal (H).

8. Device according to one of the preceding claims, **characterized in that** the spray tubes (SR) are arranged on supports (T) which are arranged between the workpieces (W) and soluble anodes (A2).

9. Device according to Claim 8, **characterized in that** the supports (T) are formed by frames which are spanned by permeable cloth or nonwoven (V).

## Revendications

1. Dispositif destiné au traitement électrolytique de pièces à usiner (W) en forme de cartes, notamment de cartes à circuits imprimés, ayant
- des moyens de métallisation et de transport (KT), qui métallisent les pièces à usiner (W) anodiquement ou cathodiquement et les guident, en position verticale, sur un trajet de transport horizontal (TW) à travers au moins un bain de traitement,
- une cellule de traitement (BZ) destinée à recevoir le bain de traitement,
- des électrodes, disposées des deux côtés du trajet de transport (TW) dans les cellules de traitement (BZ) et qui ont la polarité opposée à celle des moyens de métallisation et de transport (KT),
- des fentes verticales (S) dans les parois avant de la cellule de traitement destinées au passage des pièces à usiner (W),
- un bac collecteur (AW) pour le liquide du bain qui sort de la cellule de traitement (BZ) et
- au moins une pompe (P) pour recycler d'une façon continue le liquide du bain du bac collecteur (AW) dans la cellule de traitement (BZ),
**caractérisé par le fait**
**que** le recyclage du liquide du bain se fait au moins partiellement à travers des tubes pulvérisateurs (SR), qui sont disposés, dans la cellule de traitement (BZ), au moins dans la zone supérieure des pièces à usiner (W) des deux côtés du trajet de transport (TW), les tubes pulvérisateurs (SR) s'étendant dans la direction du trajet de transport (TW) et étant orientés obliquement par rapport à l'horizontale (H).

2. Dispositif selon la revendication 1
**caractérisé par le fait que** les tubes pulvérisateurs (SR) sont disposés de telle manière qu'ils forment un guidage pour les pièces à usiner (W).

3. Dispositif selon la revendication 1 ou 2
**caractérisé par le fait que** le recyclage du liquide du bain dans la cellule de traitement (BZ) se fait partiellement par l'intermédiaire d'une chambre de distribution (VK) formée dans le fond de la cellule de traitement et par l'intermédiaire d'ouvertures (O) de la chambre de répartition (VK) disposées des deux côtés du trajet de transport (TW).

4. Dispositif selon la revendication 3
**caractérisé par le fait que**, dans la zone inférieure des pièces à usiner (W), des dispositifs directeurs (LV) sont disposés, dans la cellule de traitement (BZ), des deux côtés du trajet de transport (TW) et font dévier le liquide du bain, qui coule vers le haut en provenance de la chambre de distribution (VK), vers la surface des pièces à usiner (W).

5. Dispositif selon l'une des revendications précédentes
**caractérisé par le fait que** les tubes pulvérisateurs (SR) sont disposés d'une façon pivotante autour de leur axe longitudinal (LA).

6. Dispositif selon l'une des revendications précédentes
**caractérisé par le fait que** les tubes pulvérisateurs (SR) sont inclinés, par rapport à l'horizontale (H), sous un angle (α) compris entre 5° et 30°.

7. Dispositif selon l'une des revendications précédentes
**caractérisé par le fait que** les tubes pulvérisateurs (SR) sont inclinés, par rapport à l'horizontale (H), sous un angle (α) compris entre 5° et 15°.

8. Dispositif selon l'une des revendications précédentes
**caractérisé par le fait que** les tubes pulvérisateurs (SR) sont montés sur des supports (T) disposés entre les pièces à usiner (W) et des anodes solubles (A2).

9. Dispositif selon la revendication 8
**caractérisé par le fait que** les supports (T) sont formés par des cadres recouverts de toile ou de voile (V) perméable.
